Europäisches Patentamt

European Patent Office

Office européen des brevets

(11) Veröffentlichungsnummer: **0 373 235**
**A1**

## EUROPÄISCHE PATENTANMELDUNG

(21) Anmeldenummer: 88120736.9

(22) Anmeldetag: **12.12.88**

(51) Int. Cl.⁵: **H01L 31/02, H01L 31/042, H01L 31/048**

(43) Veröffentlichungstag der Anmeldung:
**20.06.90 Patentblatt 90/25**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Cammerer, Fritz, Dr.**
**Delpstrasse 15**
**D-8000 München 80(DE)**
Erfinder: **Bednorz, Klaus**
**Leopoldstrasse 138**
**D-8000 München 40(DE)**
Erfinder: **Riermeier, Manfred**
**Finkweg 1**
**D-8059 Oberneuching(DE)**

(54) **Solarzelleneinrichtung.**

(57) Eine Solarzelleneinrichtung mit einem Substrat und/oder Superstrat soll eine einfache Montage ermöglichen. Zur Montage einer rahmenlosen Solarzelleneinrichtung sind Klemmen vorgesehen.

## FIG 1

## Solarzelleneinrichtung

Die Erfindung betrifft eine Solarzelleneinrichtung nach dem Oberbegriff des Anspruchs 1.

Bekannte Solarzelleneinrichtungen besitzen häufig einen Rahmen, der verschiedenen Zwecken dienen kann, beispielsweise dem Kantenschutz, der mechanischen Stabilität der Solarzelleneinrichtung, dem Feuchteschutz und der örtlichen Befestigung der Solarzelleneinrichtung.

Bekannte Solarzelleneinrichtungen mit Rahmeneinrichtungen erfordern einen großen Aufwand bezüglich der Rahmeneinrichtungen und der Montage, insbesondere hinsichtlich Material und Kosten.

Der vorliegenden Erfindung liegt die Aufgabe zugrunde, eine Solarzelleneinrichtung der eingangs genannten Art anzugeben, die eine einfache Montage ermöglicht.

Diese Aufgabe wird erfindungsgemäß durch eine Solarzelleneinrichtung nach dem Anspruch 1 gelöst.

Zur Montage von rahmenlosen Solarzelleneinrichtungen, beispielsweise zur Montage von rahmenlosen Solarzellenmodulen, können Klemmen verwendet werden, wie sie in der Glastechnik üblicherweise zur Befestigung von Brüstungsgläsern, Glastüren, Glasfassaden und ähnlichen Gegenständen benutzt werden. Die Montage von Solarzelleneinrichtungen mit Hilfe von entsprechend ausgestalteten Pratzen kann zusätzlich ermöglichen, daß kein Zug und keine Biegung auf Substrat und/oder Superstrat der Solarzelleneinrichtung ausgeübt werden. Dies ist besonders vorteilhaft bei Verwendung von Glas zur mechanischen Stabilisierung von Solarzelleneinrichtungen. Solarzelleneinrichtungen können beispielsweise mit Hilfe von Glasscheiben oder mit Hilfe von Glasfasern mechanisch stabilisiert werden.

Die zur Montage der Solarzelleneinrichtungen verwendeten Pratzen können vorteilhafterweise auch dazu verwendet werden, den bei bekannten Solarzelleneinrichtungen erforderlichen großen Aufwand bezüglich der Stromführung von Solarstrom zu vermindern. Zu diesem Zweck können die zur Montage der Solarzelleneinrichtungen verwendeten Pratzen zumindest teilweise zur Bereitstellung von elektrischen Kontakten der Solarzelleneinrichtungen verwendet werden. Dabei können die zur Montage der Solarzelleneinrichtungen verwendeten Pratzen zumindest teilweise direkt als elektrische Kontakte ausgebildet sein. Diese als elektrische Kontakte direkt ausgebildeten Pratzen können zumindest mit einer Solarzelle der Solarzelleneinrichtung elektrisch verbunden sein. Es ist vorteilhaft, daß wenigstens eine zur Montage der Solarzelleneinrichtungen vorgesehene Pratzen die Funktion einer Anschlußdose bzw. eines Anschlußkastens ausübt. Dies bedeutet, daß wenigstens eine der Pratzen so ausgebildet ist, daß sie zumindest eine Einrichtung zur Führung von elektrischer Verdrahtung und/oder zur Aufnahme von Bypass-Dioden und/oder zur Zugentlastung der zur Stromführung von Solarstrom verwendeten Verkabelung aufweist. Zu diesem Zweck kann wenigstens eine Pratze einen Hohlraum aufweisen zur Aufnahme von elektrischer Verdrahtung und/oder Bypass-Dioden. Zu diesem Zweck kann wenigstens eine Pratze eine Einrichtung zum Klemmen von elektrischer Verdrahtung aufweisen. Zu diesem Zweck kann wenigstens eine Pratze einen elektrischen Stecker und/oder eine elektrische Buchse aufweisen. Zur Zugentlastung kann elektrische Verdrahtung bei einer Pratze auf einem elektrischen Kontakt auch punktgeschweißt werden.

Ausgestaltungen und Vorteile der Erfindung sind in den Unteransprüchen, der Beschreibung und der Zeichnung dargestellt.

Querschnitte von Pratzen von Solarzelleneinrichtungen können ausreichend groß ausgebildet werden und können so leicht die in der Solarzelleneinrichtung erzeugten hohen elektrischen Ströme aufnehmen.

Die Erfindung ermöglicht eine Verringerung der Verschaltungen im Inneren der Solarzelleneinrichtung.

Die Erfindung ermöglicht eine Verringerung der Feldverkabelung.

Einzelne Solarzelleneinrichtungen können direkt miteinander verschaltet werden.

Die Erfindung ermöglicht einen einfachen Aufbau von Parallel-und/oder Serienschaltungen von Solarzelleneinrichtungen.

Als Solarzelleneinrichtungen können alle Einrichtungen verwendet werden, die Solarzellen aufweisen und mit Pratzen versehen werden können. Beispielsweise können alle Solarmodule verwendet werden.

Als Solarzelleneinrichtungen können beispielsweise Solarmodule verwendet werden, die in der Doppelglas-Technologie hergestellt sind. In der Doppelglas-Technologie werden solche Solarzellen zusammen mit ihrer elektrischen Beschaltung zwischen zwei Glasscheiben mit Hilfe von Kunststoff in flüssiger Form oder mit Hilfe von Thermoplast-Folienmaterial eingebettet.

Als Solarzelleneinrichtungen können auch Solarmodule verwendet werden, die in der Superstrat-Technik hergestellt worden sind. Dabei wird auf der Vorderseite eines Solarmoduls ebenfalls eine Glasscheibe zur Abdeckung verwendet, während die Rückseite des Solarmoduls aus Kunststoff-Folien, beispielsweise aus Aluminiumbeschichteten Folien, aufgebaut ist. Zwischen Vorderseite und Rückseite des Solarmoduls sind wiederum die Solarzellen zusammen mit ihrer elektrischen Beschaltung mit Hilfe von Thermoplast-Folien eingebettet. Verfahren zur Herstellung von solchen Solarmodulen sind beispielsweise in den US-Patentschriften 4 067 764, 4 224 081, 4 231 807, 4 317 739, 4 433 200 und 4 401 839 angegeben.

Die Pratzen von Solarzelleneinrichtungen können Profile aus Aluminium oder Stahl aufweisen, die beispielsweise mit Silikon abgedichtet sind.

Bei der Erfindung kann vorteilhafterweise ein Solarmodul verwen det werden, wie es in der US-Patentschrift 4 567 316 bzw. in der europäischen Offenlegungsschrift der Anmeldenummer 84 102 071.2 beschrieben ist. Bei diesem Solarzellenmodul sind einzelne Solarzellen in Reihen angeordnet, die wenigstens teilweise elektrisch in Serie geschaltet sind. Bypassdioden sind parallel zu einzelnen Ketten dieser Solarzellen geschaltet, um die Heizleistung in partiell abgeschatteten Solarzellen zu begrenzen.

Diese Bypassdioden sind direkt in das Solarzellenmodul integriert, so daß allein für diese Bypassdioden ein aufwendiger Anschlußkasten nicht erforderlich ist und bei der vorliegenden Erfindung nur noch zwei Anschlüsse aus dem Solarzellenmodul herausgeführt werden müssen.

Vorteilhafterweise werden Solarzelleneinrichtungen mit Hilfe von Glasscheiben oder mit Hilfe von Glasfasern mechanisch stabilisiert und mit Pratzen zur Führung von Strom, der in der Solarzelleneinrichtung erzeugt worden ist, versehen.

Vorteilhafterweise werden bei der Erfindung Solarzelleneinrichtungen verwendet, die mit einem Minimum an elektrischer Verdrahtung auskommen. Beispielsweise können Solarzellen mit Hilfe von einem Substrat oder Superstrat mechanisch stabilisiert werden, wobei das Substrat bzw. das Superstrat elektrisch leitfähige Bereiche wie Metallisierungen oder elektrisch leitfähige Kunststoffe zur elektrischen Verbindung zwischen Solarzellen und Solarzellen bzw. Solarzellen und elektrisch leitfähigen Pratzen aufweisen.

Die Pratzen können Strom von Solarzellenketten abnehmen. Eine Solarzelleneinrichtung kann jedoch auch eine einzelne Solarzelle aufweisen. Außerdem können mehrere Pratzen auch von mehreren Solarzellen innerhalb der Solarzelleneinrichtung Strom abnehmen.

Die Pratzen können aus Metall bzw. aus einem elektrisch leitfähigem Kunststoff oder aus einer Kombination von Metall und elektrisch leitfähigem Kunststoff bestehen.

Die Pratzen können mehrere Pole aufweisen.

Solarzellen können direkt mit Pratzen elektrisch leitend verbunden sein. Solarzellen können jedoch auch mit elektrisch leitfähigen Bändchen oder mit anderen elektrisch leitfähigen Verdrahtungen versehen werden und mit solchen Einrichtungen untereinander und/oder mit Pratzen elektrisch verbunden werden.

Elektrische Verbindungen, wie sie bei einer Solarzelleneinrichtung mit Pratzen nach der Erfindung erforderlich sind, können durch Löten, Schweißen, Klemmen, durch Verwendung von elektrisch leitendem Kleber oder durch jede andere Maßnahme, die dem Fachmann bekannt ist, hergestellt werden. Für den Stromübergang zu Pratzen hin eignen sich auch leitfähige Gummimassen bzw. elektrisch leitfähige Dichtungsmassen.

Elektrische Verbindungen zwischen verschiedenen Solarzellen oder zwischen Solarzelle und Pratzen können durch elektrisch leitfähige Folien oder durch elektrisch leitfähige Metallisierungen oder durch elektrisch leitfähige Kunststoffbereiche auf einem Substrat (Leiterplatte) und/oder Superstrat (Glasscheibe) hergestellt werden.

Elektrische Verbindungen zwischen verschiedenen Solarzellen und/oder zwischen Solarzellen und Pratzen können durch Anwendung der Leiterplattentechnik hergestellt werden.

Als für die Erfindung geeignete Pratzen können Klemmbefestigungen verwendet werden, wie sie als Glasbau-Beschläge zur Befestigung für Trennwände, Balkon- und Treppengeländer bekannt sind. Die Befestigung solcher Klemmen an einer Solarzelleneinrichtung kann mit Hilfe von Quetschung und/oder mit Hilfe von Durchbohrung erfolgen.

Die Solarzellen innerhalb einer Solarzelleneinrichtung können parallel und/oder seriell verschaltet sein.

Die Erfindung wird im folgenden anhand der Zeichnung näher er läutert.

FIG 1 zeigt eine Solarzelleneinrichtung mit Pratzen nach der Erfindung.

FIG 2 erläutert die direkte elektrische Verbindung von Solarzellen.

FIG 3 zeigt eine weitere Solarzelleneinrichtung mit Pratzen nach der Erfindung.

FIG 4 bis 9 erläutern Einzelheiten der Erfindung.

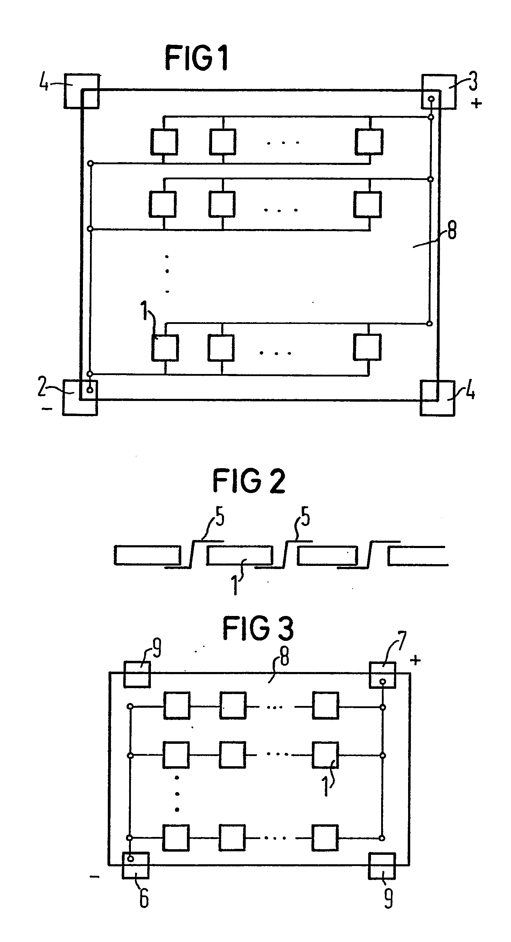

FIG 1 zeigt eine Solarzelleneinrichtung mit Solarzellen 1. Die Pratzen 2, 3 sind elektrisch leitfähig, die Pratzen 4 sind zumindest elektrisch von den Pratzen 2, 3 isoliert. Die Solarzellen 1 und die Pratzen 2, 3 sind so miteinander verschaltet, daß alle Solarzellen parallel zueinander geschaltet sind und daß die Pratze 2 den Minuspol der gesamten Solarzelleneinrichtung und die Pratze 3 den Pluspol der gesamten Solarzelleneinrichtung bildet.

Die Solarzellen 1 können dabei mit Hilfe von zusätzlicher elektrischer Verdrahtung miteinander elektrisch verbunden sein. Die Solarzellen 1 können jedoch auch durch elektrisch leitfähige Bereiche auf Substrat und/oder Superstrat direkt miteinander verbunden sein. Die Solarzellen 1 können Rand an Rand angeordnet sein.

FIG 2 zeigt Solarzellen 1, die mit Hilfe von elektrisch leitenden Einrichtungen 5, beispielsweise Bändchen, miteinander in Serie elektrisch verbunden sind.

FIG 3 zeigt eine Solarzelleneinrichtung mit Pratzen 6, 7, 9, bei der Solarzellen 1 reihenweise in Serie verschaltet sind. Verschiedene Reihen dieser seriell verschalteten Solarzellen 1 sind dabei parallel geschaltet. Die Solarzelleneinrichtung nach FIG 3 be sitzt nur vier Pratzen 6, 7, 9. Die Pratze 6 bildet dabei den Minuspol, die Pratze 7 den Pluspol.
Als Pratzen können bei der Erfindung Profilteile verwendet werden, die als Strangußteile oder Strangpressteile hergestellt werden können.

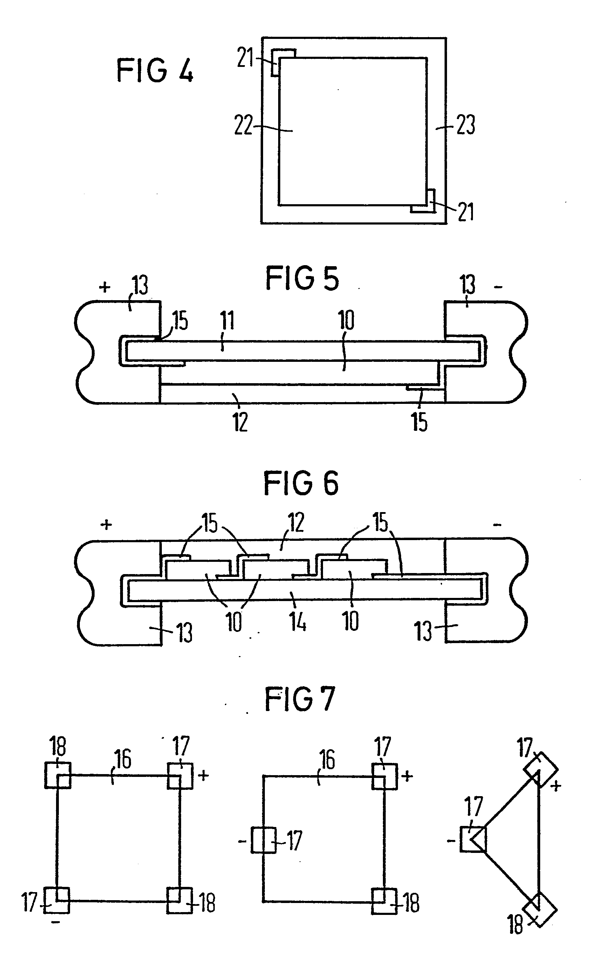

FIG 4 zeigt eine Draufsicht auf ein Solarmodul ohne Rahmeneinrichtung, das für die Erfindung verwendbar ist. Die in der FIG 4 nicht dargestellten Solarzellen sind mit einer Thermoplast-Folie 22 bedeckt. Das Solarmodul 19 besitzt eine Glasscheibe 23 als Superstrat. Die elektrische Verbindung zwischen den Solarzellen des Solarmoduls 19 und der gemäß der Erfindung anzubringenden Rahmeneinrichtung wird durch metallisierte Flächen 21 auf dem Glas 23 erzielt.

FIG 5 und 6 zeigen Solarzelleneinrichtungen nach der Erfindung im Schnitt. In FIG 7 ist eine einzige Solarzelle 10 gezeigt. Als Superstrat ist eine Glasscheibe 11 verwendet. Die Glasscheibe 11 zusammen mit der Solarzelle 10 ist dabei mit zwei Pratzen 13 versehen. Die beiden Pratzen 13 sind elastisch auf die Glasscheibe 11 gedrückt oder auf die Glasscheibe 11 aufgesetzt und verschraubt. Die Pratzen können auch aus elektrisch leitfähigem Kunststoff bestehen. Die Rahmenteile 13 sind über elektrische Verbindungen 15 direkt mit der Solarzelle 10 elektrisch verbunden. Die elektrischen Verbindungen 15 können elektrisch leitfähige Folien oder elektrisch leitfähige Metallisierungen oder elektrisch leitfähige Kunststoffbereiche sein.

FIG 6 zeigt ein Solarmodul, das ähnlich wie die Solarzelleneinrichtung nach FIG 5 aufgebaut ist. Das Solarmodul nach FIG 6 besitzt mehrere Solarzellen 10. Anstelle der Glasscheibe 11 ist in FIG 6 ein Substrat 14 (Leiterplatte) vorgesehen. Die Solarzellen 10 in FIG 5 und 6 können mit Kunststoff 12 bedeckt sein.

Bei einer Solarzelleneinrichtung nach der Erfindung kann vorteilhafterweise auf eine zusätzliche Anschlußbox verzichtet werden. Bypassdioden können direkt in die Solarzelleneinrichtung integriert werden. Solarzelleneinrichtungen nach der Erfindung besitzen vorteilhafterweise als Substrat und/oder Superstrat eine Glasscheibe 8.

FIG 7 zeigt drei Solarmodule 16, die Pratzen 17 als elektrische Kontakte aufweisen. Die Pratzen 18 sind bezüglich der Solargeneratorspannung elektrisch isoliert. Die Pratzen 17 und 18 können dabei Eckpratzen sein, wie sie in der Glastechnik üblich sind.

Die in der FIG 7 gezeigten Solarmodule 16 können auch solche Pratzen aufweisen, die im Inneren oder an ihrer Oberfläche einen Hohlraum aufweisen, in dem elektrische Verdrahtung und/oder Bypass-Dioden untergebracht sein können. Dabei kann elektrische Verdrahtung aus dem Inneren des Solarmoduls heraus zu einer Buchse geführt sein. Dabei kann ein Solarmodul 16 in seinem Randbereich einen elektrischen Kontakt, beispielsweise eine Metallisierung 21 wie in FIG 4 gezeigt, aufweisen. Wenn eine Pratze ein U-förmiges Profil zur Aufnahme des Solarmoduls 16 aufweist, kann im Inneren dieses U-förmigen Profils ein elektrischer Kontakt vorgesehen sein, der mit der elektrisch leitfähigen Fläche 21 eine elektrische Verbindung eingeht. Bei dieser Pratze kann als elektrischer Anschluß nach außen entweder eine Buchse oder ein elektrisches Kabel, das aus der Pratze herausgeführt ist, vorgesehen sein. Die Pratze kann dabei insgesamt aus elektrisch leitfähigem Material bestehen oder nur in soweit aus elektrisch leitfähigem Material bestehen, wie es zur Herstellung eines elektrischen Kontakts nach außen erforderlich ist.

Bei der Erfindung kann wenigstens eine Pratze die Funktion einer sonst üblichen Anschlußbox übernehmen.

Die Pratzen können mehrpolig gestaltet sein. Beispielsweise kann an einer Pratze eine Spannung von 12 Volt und an einer weiteren Prate eine Spannung von 24 Volt anliegen.

Pratzen können sowohl durch Klemmen als auch durch Kleben als auch durch Schrauben an der Solarzelleneinrichtung befestigt sein. Eine Pratze kann beispielsweise aus einer Schiene mit U-förmigem Profil bestehen. Diese U-förmige Schiene kann durch Kleben mit der Solarzelleneinrichtung verbunden sein.

Es können 2, 3, 4 oder mehrere Pratzen verwendet werden.

Eine Pratze kann aus Metall und/oder Kunststoff bestehen.

Die Erfindung ist insbesondere für rahmenlose Solarzelleneinrichtungen vorteilhaft, weil damit Aufwand an Material und Kosten eingespart werden kann. Die Pratzen sind dabei insbesondere zur Halterung der Solarzelleneinrichtungen gedacht. Darüber hinaus kann immer noch eine Rahmeneinrichtung vorhanden sein zum Feuchteschutz, Kantenschutz, mechanische Stabilisierung der Solarzelleneinrichtung usw.

Mit Hilfe von Pratzen kann eine Solarzelleneinrichtung auf eine Unterlage aufgeschraubt werden in ähnlicher Weise, wie dies bei bekannten Solarzelleneinrichtungen mit Hilfe von Rahmeneinrichtungen möglich ist.

Zum Kleben einer Pratze auf eine Solarzelleneinrichtung kann insbesondere eine Pratze mit strang-gepresstem Profil verwendet werden.

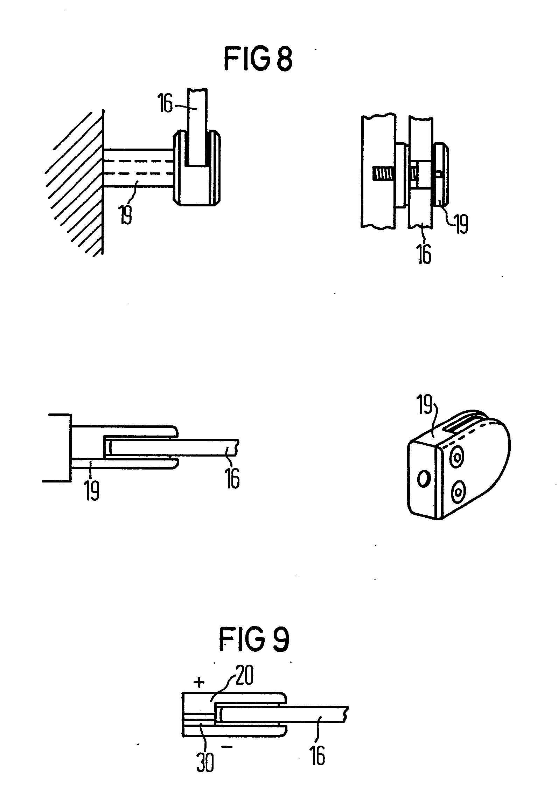

FIG 8 zeigt einige Klemmen 19, die als Glasbau-Beschläge bekannt sind und im Rahmen der Erfindung als Pratzen verwendbar sind.

FIG 9 zeigt eine Pratze 20, die an einer Solarzelleneinrichtung 16 befestigt ist. Die Pratze 20 besitzt eine elektrische Isolation 30, so daß ein Teil der Pratze 20 einen Pluspol und ein Teil der Pratze einen Minuspol bilden.

## Ansprüche

1. Solarzelleneinrichtung mit einem Substrat und/oder Superstrat, **gekennzeichnet durch** Pratzen zur Montage der insbesondere rahmenlosen Solarzelleneinrichtung.

2. Solarzelleneinrichtung nach Anspruch 1, **gekennzeichnet** durch eine Glasscheibe als Substrat und/oder Superstrat.

3. Solarzelleneinrichtung nach Anspruch 1 oder 2, **gekennzeichnet durch** Verwendung von Pratzen zur Führung von Strom, der in der Solarzelleneinrichtung erzeugt wird.

4. Solarzelleneinrichtung nach einem der Ansprüche 1 bis 3, **gekennzeichnet durch** Verwendung wenigstens einer Pratze als elektrischem Kontakt.

5. Solarzelleneinrichtung nach einem der Ansprüche 1 bis 4, **gekennzeichnet durch** Verwendung wenigstens einer Pratze zur Aufnahme von wenigstens einer Bypass-Diode.

6. Solarzelleneinrichtung nach einem der Ansprüche 1 bis 5, **gekennzeichnet durch** Verwendung wenigstens einer Pratze zur Aufnahme von elektrischen Klemmen für elektrische Verdrahtung zur Führung von Strom, der in der Solarzelleneinrichtung erzeugt wird.

7. Solarzelleneinrichtung nach einem der Ansprüche 1 bis 6, **gekennzeichnet durch** Verwendung wenigstens einer Pratze zur Zugentlastung von elektrischer Verdrahtung

8. Solarzelleneinrichtung nach einem der Ansprüche 1 bis 7, **gekennzeichnet durch** wenigstens eine Klemme als Pratze.

9. Solarzelleneinrichtung nach einem der Ansprüche 1 bis 8, **dadurch gekennzeichnet,** daß wenigstens eine Pratze mit der Solarzelleneinrichtung durch Kleber verbunden ist.

# FIG 1

# FIG 2

# FIG 3

88 P 1 8 0 6 E

FIG 4

21
22
23
21

FIG 5

+ 13
15
11
10
13 −
15
12
15

FIG 6

+
15
12
15
−
13
10
14
10
13

FIG 7

18
16
17 +
17
18
−

16
17 +
−
17
18

17
+
17
−
18

# FIG 8

16

19

19

16

19

16

19

# FIG 9

+ 20

30 − 16

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-U-8 511 432 (SIEMENS AG)<br>* Das ganze Dokument *<br>--- | 1,2 | H 01 L 31/02<br>H 01 L 31/042<br>H 01 L 31/048 |
| X | DE-A-3 513 910 (SIEMENS AG)<br>* Seiten 1-8; Abbildungen 1,4 *<br>--- | 1 | |
| D,X | US-A-4 231 807 (M.C. KEELING et al.)<br>* Das ganze Dokument *<br>--- | 1,2 | |
| X | DE-U-8 520 407 (SIEMENS AG)<br>* Das ganze Dokument *<br>--- | 1 | |
| A | DE-A-3 611 545 (VOLKSBANK REMSCHEID eG)<br>* Das ganze Dokument *<br>--- | 1 | |
| A | US-A-4 040 867 (A.F. FORESTIERI et al.)<br>* Das ganze Dokument *<br>--- | 1,6,8 | |
| A | DE-A-3 129 553 (SIEMENS AG)<br>* Patentansprüche; Seite 8, Zeile 11 - Seite 9, Zeile 4; Abbildungen 1,2 *<br>--- | 1,5 | RECHERCHIERTE SACHGEBIETE (Int. Cl.5)<br><br>H 01 L |
| A | DE-U-8 508 149 (LICENTIA PATENT-VERWALTUNGS-GmbH)<br>* Das ganze dokument *<br>----- | 1,6-8 | |

Der vorliegende Recherchenbericht wurde für alle Patentansprüche erstellt

| Recherchenort | Abschlußdatum der Recherche | Prüfer |
|---|---|---|
| DEN HAAG | 10-08-1989 | VISENTIN A. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.......................................................................................
& : Mitglied der gleichen Patentfamilie, übereinstimmendes Dokument